# EUROPÄISCHE PATENTSCHRIFT

(11) **EP 2 655 068 B1**
(45) Veröffentlichungstag und Bekanntmachung des Hinweises auf die Patenterteilung: **08.04.2015**
(21) Anmeldenummer: 11808592.7
(22) Anmeldetag: 21.12.2011
(51) Int. Cl.: B41F 17/24, B41J 11/06, H05K 3/12, H01L 21/677, B41F 15/08, B41F 15/26, B41J 11/20

(54) **DRUCKTISCHANORDNUNG, VERFAHREN ZUM BETREIBEN EINER DRUCKTISCHANORDNUNG**
PRINTING TABLE ASSEMBLY, METHOD FOR OPERATING A PRINTING TABLE ASSEMBLY
AGENCEMENT DE TABLE D'IMPRESSION, PROCÉDÉ POUR METTRE EN SERVICE UN AGENCEMENT DE TABLE D'IMPRESSION

(30) Priorität: 21.12.2010 DE 102010056123
(43) Veröffentlichungstag der Anmeldung: 30.10.2013
(73) Patentinhaber: Ekra Automatisierungssysteme GmbH, 74357 Bönnigheim (DE)
(72) Erfinder: VEGELAHN, Torsten, 75447 Sternenfels (DE); HEUPEL, Alfred, 74074 Heilbronn (DE); BERGMOSER, Stephan, 85290 Geisenfeld (DE); HAMMANN, Michael, 75038 Oberderdingen (DE)
(74) Vertreter: Clarenbach, Carl-Philipp
(86) Internationale Anmeldenummer: PCT/EP2011/006470
(87) Internationale Veröffentlichungsnummer: WO 2012/084223

(56) Entgegenhaltungen:
- EP-A2- 1 886 812
- DE-A1-102008 051 052
- US-A1- 2008 251 019
- US-A1- 2010 313 773

## Beschreibung

Die Erfindung betrifft eine Drucktischanordnung mit wenigstens einer Druckeinrichtung zum Bedrucken von Substraten und mit mindestens einem Drucktisch, der eine erste Transporteinrichtung zum Transportieren der zu bedruckenden Substrate in einer ersten Ebene und eine Hubeinrichtung zum Verfahren der ersten Transporteinrichtung mit der ersten Ebene zwischen einer der Druckeinrichtung zugeordneten Druckebene und einer darunterliegenden Transportebene aufweist.

Ferner betrifft die Erfindung ein Verfahren zum Betreiben einer Drucktischanordnung, wie sie oben beschrieben wurde, mit wenigstens einer Druckeinrichtung zum Bedrucken von Substraten und mit mindestens einem Drucktisch, der eine erste Transporteinrichtung zum Transportieren der zu bedruckenden Substrate in einer ersten Ebene und eine Hubeinrichtung zum Verfahren der ersten Transporteinrichtung mit der ersten Ebene zwischen einer der Druckeinrichtung zugeordneten Druckebene und einer darunterliegenden Transportebene aufweist.

Drucktischanordnungen sowie Verfahren zum Betreiben derer sind aus dem Stand der Technik weitläufig bekannt. Sie weisen in der Regel einen Drucktisch auf, dem ein Substrat, wie beispielsweise eine Leiterplatte, eine Keramikplatte, ein Solarzellensubstrat, eine Folie oder dergleichen mittels einer Zuführeinrichtung zuführbar ist. Der Drucktisch selbst weist eine erste Transporteinrichtung auf, die zum Transportieren und gegebenenfalls zum Ausrichten des Substrats einer ersten Ebene dient. Unter den hier genannten Ebenen sind jeweils gedachte Ebenen zu verstehen, die sich parallel zu der Druckeinrichtung beziehungsweise zumindest im Wesentlichen senkrecht zur Druckrichtung der Druckeinrichtung erstrecken. Weiterhin ist es bekannt, Drucktische derartiger Drucktischanordnungen mit einer Hubeinrichtung zu versehen, welche die erste Transporteinrichtung mit der ersten Ebene zwischen einer der Druckeinrichtung zugeordneten Druckebene und einer darunterliegenden Transportebene bei Bedarf verfährt. Hierbei wird also unterschieden zwischen einer Transportebene, in welcher das oder die Substrate durch die Drucktischanordnung transportiert werden, sowie der Druckebene, in welcher die Substrate durch die Druckeinrichtung bedruckbar sind. Mittels der Hubeinrichtung werden die Substrate, die von der ersten Transporteinrichtung transportiert werden, aus der Transportebene in die Druckebene in Richtung der Druckeinrichtung gehoben, um den Abstand zwischen Druckeinrichtung und Substrat für den Druckvorgang optimal einzustellen.

Eine gattungsgemäße Drucktischanordnung geht beispielsweise aus der EP 1 886 812 A2 hervor.

Nachteilig bei bekannten Drucktischanordnungen ist es, dass während des Druckvorgangs die Drucktischanordnung für die Zuführung weiterer Substrate gesperrt ist, wodurch insbesondere bei einer Massenfertigung Zeit verlorengeht.

Der Erfindung liegt somit die Aufgabe zugrunde, eine Drucktischanordnung sowie ein Verfahren zum Betreiben einer Drucktischanordnung zu schaffen, die eine zeitoptimierte Bearbeitung beziehungsweise Bedruckung von Substraten ermöglichen.

Die der Erfindung zugrunde liegende Aufgabe wird durch die Merkmale der unabhängigen Ansprüche gelöst. Die erfindungsgemäße Drucktischanordnung hat den Vorteil, dass während ein Substrat bedruckt und/oder mittels der ersten Transporteinrichtung ausgerichtet wird, ein weiteres Substrat durch die Drucktischanordnung gefördert werden kann. Die erfindungsgemäße Drucktischanordnung zeichnet sich dadurch aus, das der erste Drucktisch eine zweite Transporteinrichtung zum Transportieren von Substraten in einer zweiten Ebene unterhalb der ersten Ebene aufweist, wobei der feste Abstand zwischen der ersten Ebene und der zweiten Ebene dem Abstand zwischen der Druckebene und der Transportebene entspricht. Der Drucktisch umfasst also zwei Transporteinrichtungen, die zum Transportieren von Substraten in unterschiedlichen Ebenen ausgebildet sind. Vorzugsweise sind die Ebenen parallel zueinander ausgerichtet, wobei die zweite Ebene unterhalb der ersten Ebene, also auf der der Druckeinrichtung gegenüberliegenden Seite der ersten Ebene, liegt. Der Abstand zwischen der ersten und der zweiten Ebene ist fest gewählt und entspricht dem Abstand zwischen der Druckebene und der Transportebene, zwischen welchen die erste Ebene mittels der Hubeinrichtung verfahrbar ist. Dies hat zur Folge, dass wenn die erste Transporteinrichtung mit der ersten Ebene aus der Transportebene in die Druckebene verfahren ist, die zweite Transporteinrichtung mit der zweiten Ebene in der Transportebene liegt. Während nun die Druckeinrichtung das in der ersten Ebene beziehungsweise in der Druckebene liegende Substrat bedruckt beziehungsweise bedrucken kann und/oder das Substrat durch die erste Transporteinrichtung ausgerichtet wird, kann mittels der zweiten Transporteinrichtung in der Transportebene ein weiteres Substrat durch den Drucktisch transportiert werden. Bei dem weiteren Substrat kann es sich beispielsweise um ein in der Zuführung zu der Drucktischanordnung als Fehlteit ausgernustertes Substrat handeln, das dann durch die zweite Transporteinrichtung durch die Drucktischanordnung hindurch transportiert wird, während das erste Substrat bedruckt wird. Ebenso kann es sich bei dem weiteren Substrat um ein zu bedruckendes Substrat handeln, das von der zweiten Transporteinrichtung zu einer zweiten Druckstation, insbesondere zu einem weiteren Drucktisch, gefördert wird. Der wesentliche Vorteil der vorliegenden Erfindung liegt somit darin, dass, während ein Substrat bedruckt wird, ein weiteres Substrat durch den Drucktisch und die Drucktischanordnung hindurch transportierbar ist, um insbesondere an anderer Steile weiterverarbeitet zu werden.

Vorzugsweise ist dem Drucktisch eine Zuführeinrichtung zum Zuführen der Substrate in der Transportebene zugeordnet. Bei der Zuführeinrichtung handelt es sich vorzugsweise ebenfalls um eine Einrichtung, die die Substrate in einer Ebene, insbesondere linear, fördert beziehungsweise transportiert. Durch die Anordnung in der Transportebene werden die von der Zuführeinrichtung zugeführten Substrate der in der Transportebene liegenden ersten oder zweiten Transporteinrichtung des Drucktischs zugeführt, wobei mittels der Hubeinrichtung wählbar ist, welcher der Transporteinrichtungen das Substrat zugeführt wird.

Bevorzugt weist die Drucktischanordnung mindestens einen insbesondere dem oben beschriebenen (ersten) Drucktisch entsprechenden weiteren (zweiten) Drucktisch auf, der in Transportrichtung hinter dem Drucktisch angeordnet ist und mindestens eine weitere erste Transporteinrichtung zum Transportieren zu bedruckender Substrate in einer ersten Ebene und eine weitere Hubeinrichtung zum Verfahren der weiteren ersten Transporteinrichtung mit deren ersten Ebene zwischen der Druckebene und der darunterliegenden Transportebene aufweist. Die Drucktischanordnung umfasst somit mindestens zwei Drucktische, die in Transportrichtung gesehen hintereinander angeordnet sind. Die weitere erste Transporteinrichtung des weiteren Drucktischs lässt sich mit der ersten Ebene ebenfalls zwischen der Druckebene und der Transportebene der Drucktischanordnung verfahren. Vorzugsweise ist der weitere Drucktisch derart angeordnet, dass ein von dem Drucktisch in der Transportebene transportiertes Substrat dem weiteren Drucktisch übergebbar ist. Hierdurch ist es insbesondere möglich, das von der zweiten Transporteinrichtung in der Transportebene transportierte Substrat der weiteren ersten Transporteinrichtung des weiteren Drucktischs zuzuführen, wobei die weitere erste Transporteinrichtung dann durch die weitere Hubeinrichtung in die Druckebene beziehungsweise in eine Druckposition verfahrbar ist. Somit wird bevorzugt während ein erstes Substrat auf dem ersten Drucktisch bedruckt wird, ein weiteres Substrat durch den ersten Drucktisch in der Transportebene mittels der zweiten Transporteinrichtung transportiert und dem weiteren Drucktisch beziehungsweise dessen weiterer ersten Transporteinrichtung zugeführt, sodass gleichzeitig ein Bedrucken und Transportieren von Substraten möglich ist.

Besonders bevorzugt weist der weitere Drucktisch eine weitere zweite Transporteinrichtung zum Transportieren von Substraten in einer zweiten Ebene unterhalb der ersten Ebene auf, wobei der feste Abstand zwischen der ersten Ebene und der zweiten Ebene der weiteren Transporteinrichtungen dem Abstand zwischen der Druckebene und der Transportebene entspricht. Die Ausbildung des weiteren Drucktischs entspricht somit der des zuvor beschriebenen Drucktischs, sodass auch durch den weiteren Drucktisch ein Substrat förderbar ist, während ein anderes Substrat auf der weiteren ersten Transporteinrichtung bedruckt wird. Die erste Transporteinrichtung und die weitere erste Transporteinrichtung werden bevorzugt abwechselnd mittels der jeweiligen Hubeinrichtung in die Transportebene verfahren, sodass insbesondere der weiteren ersten Transporteinrichtung des zweiten Drucktischs ein Substrat zugeführt wird, während an dem ersten Drucktisch ein Substrat bedruckt wird und an dem zweiten Drucktisch ein Substrat bedruckt wird, während das bedruckte Substrat des ersten Drucktischs mittels der weiteren zweiten Transporteinrichtung des weiteren Drucktischs aus der Drucktischanordnung heraus transportierbar ist.

Vorzugsweise sind die in der Transportebene oder in der Druckebene liegenden, benachbarten Transporteinrichtungen der Drucktische jeweils zur Weiterleitung der Substrate von einer Transporteinrichtung eines der Drucktische zu der benachbarten Transporteinrichtung des benachbarten Drucktischs ausgebildet. Die Transporteinrichtungen sind also derart ausgerichtet und/oder ausgebildet, dass die Substrate von einem Drucktisch zum benachbarten Drucktisch weitergegeben beziehungsweise -transportiert werden können, wenn sie benachbart in der Transportebene oder in der Druckebene liegen.

Gemäß einer vorteilhaften Weiterbildung der Erfindung ist vorgesehen, dass die erste und die zweite Transporteinrichtung des jeweiligen Drucktischs übereinander oder seitlich versetzt zueinander angeordnet sind. Sind die erste und die zweite Transporteinrichtung eines Drucktischs übereinander angeordnet, so liegen sie sich überdeckend in der jeweiligen Ebene, sodass der jeweilige Drucktisch schmal gebaut ist. Sind die Transporteinrichtungen nebeneinander beziehungsweise seitlich versetzt zueinander in der jeweiligen Ebene angeordnet, so ist der Drucktisch zwar breiter gebaut, jedoch lässt sich hierdurch der Abstand zwischen den Ebenen verringern. Die erste Transporteinrichtung des einen Drucktischs und die weitere zweite Transporteinrichtung des weiteren Drucktischs sowie die zweite Transporteinrichtung des einen Drucktischs und die weitere erste Transporteinrichtung des weiteren Drucktischs sind vorzugsweise jeweils zum Transport der gleichen Substrate beziehungsweise von Substraten mit der gleichen Breite ausgebildet und bilden somit jeweils eine Transportlinie. Alternativ können die jeweiligen Transportlinien auch unterschiedliche Breiten aufweisen, sodass an dem einen Drucktisch stets ein Substrat mit einer ersten Breite und an dem weiteren Drucktisch stets ein Substrat mit einer davon abweichenden Breite und/oder Länge bedruckt wird. Hierdurch lassen sich auf kostengünstige und effiziente Art und Weise mittels der gleichen Drucktischanordnung unterschiedlich geformte Substrate zeitoptimiert bedrucken. Sind die erste und die zweite Transporteinrichtung nebeneinander angeordnet, so weist die Drucktischanordnung jeweils eine der jeweiligen Transporteinrichtung zugeordnete Zuführeinrichtung in der Transportebene auf.

Gemäß einer vorteilhaften Weiterbildung ist bevorzugt vorgesehen, dass die Druckeinrichtung einen Druckkopf für mehrere Drucktische und/oder wenigstens einen Druckkopf für jeweils einen der Drucktische aufweist. Ist jeweils ein Druckkopf vorgesehen, so kann an jedem der Drucktische ein Druckvorgang unabhängig erfolgen. Durch die vorteilhafte Ausbildung der Drucktischanordnung ist es auch möglich, ein Substrat zu bedrucken, das sich über die Transportlänge beider Drucktische erstreckt. Hierzu werden die Drucktische mit ihrer jeweiligen ersten Transporteinrichtung in die Transportebene verfahren, das Substrat zugeführt und die beiden ersten Transporteinrichtungen gleichzeitig in die Druckebene mittels der Hubeinrichtungen verlagert, um dort von der Druckeinrichtung mit dem einen oder auch mit mehreren Druckköpfen bedruckt zu werden.

Das erfindungsgemäße Verfahren zeichnet sich dadurch aus, dass der erste Drucktisch mit einer zweiten Transporteinrichtung zum Transportieren von Substraten in einer zweiten Ebene unterhalb der ersten Ebene versehen wird, wobei der feste Abstand zwischen der ersten Ebene und der zweiten Ebene dem Abstand zwischen der Druckebene und der Transportebene entspricht, mit folgenden Schritten: Zunächst wird die erste Transporteinrichtung mit der ersten Ebene in die Transportebene verfahren. Anschließend wird ein erstes Substrat der ersten Transporteinrichtung des Drucktischs zugeführt. Anschließend wird die erste Transporteinrichtung mit der ersten Ebene in die Druckebene zum Bedrucken des Substrats mittels der Druckeinrichtung verfahren. Schließlich wird ein zweites Substrat zu der nun in der Transportebene liegenden zweiten Transporteinrichtung zugeführt, und mittels der zweiten Transporteinrichtung durch den ersten Drucktisch hindurch transportiert, während die Druckeinrichtung das erste Substrat bedruckt. Hierdurch ergeben sich die oben bereits beschriebenen Vorteile. Als Vorbereitung für den Druckvorgang wird bevorzugt das erste Substrat mittels der ersten Transporteinrichtung des Drucktischs bezüglich der Druckeinrichtung ausgerichtet. Hierzu können bekannte Verfahren wie beispielsweise optische Verfahren zur Erfassung der Ausrichtung des Substrats auf der ersten Transporteinrichtung genutzt werden.

Vorzugsweise wird das zweite Substrat einer weiteren ersten Transporteinrichtung eines weiteren Drucktischs durch die zweite Transporteinrichtung des einen Drucktischs zugeführt.

Besonders bevorzugt wird die weitere erste Transporteinrichtung des weiteren Drucktischs mittels einer Hubeinrichtung in die Transportebene zum Bedrucken des zweiten Substrats durch die Druckeinrichtung verlagert.

Ferner wird bevorzugt die erste Transporteinrichtung des Drucktischs mit dem bedruckten ersten Substrat in die Transportebene verfahren und das bedruckte erste Substrat durch die erste Transporteinrichtung des Drucktischs einer weiteren zweiten Transporteinrichtung des weiteren Drucktischs zugeführt, während die Druckeinrichtung das zweite Substrat auf dem weiteren Drucktisch bedruckt.

Insgesamt werden somit eine Drucktischanordnung sowie ein Verfahren zu deren Betreiben geboten, die auf einfache Art und Weise eine Zeitersparnis insbesondere bei einer Massenfertigung von Substraten bieten.

Im Folgenden soll die Erfindung anhand der Zeichnung näher erläutert werden. Dazu zeigen
- Figur 1: eine vorteilhafte Drucktischanordnung in einer vereinfachten Darstellung,
- Figur 2: die Drucktischanordnung in einem ersten Druckzustand,
- Figur 3: die Drucktischanordnung in einem zweiten Druckzustand,
- Figur 4: eine vorteilhafte Ausführungsform der Drucktischanordnung für unterschiedlich große Substrate,
- Figur 5: eine vorteilhafte Ausführungsform der Drucktischanordnung für Substrate mit Überlänge und
- Figur 6: eine vorteilhafte Ausführungsform der Drucktischanordnung für Substrate mit unterschiedlicher Breite.

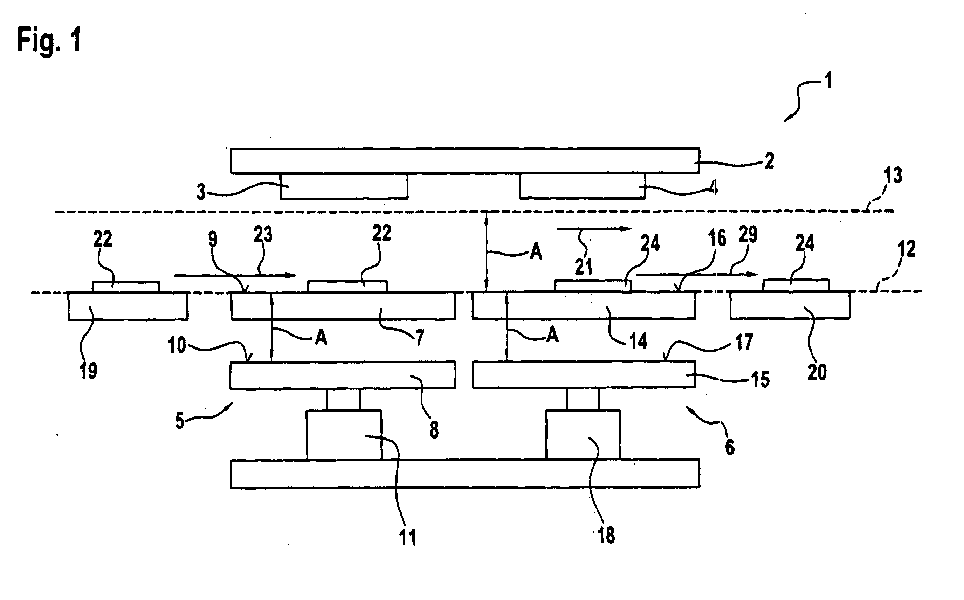

Figur 1 zeigt in einer vereinfachten Darstellung eine Drucktischanordnung 1 zum Bedrucken von Substraten, wie beispielsweise Leiterplatten, Keramikplatten, Solarzellensubstrate, Folien oder dergleichen. Hierzu weist die Drucktischanordnung 1 eine Druckeinrichtung 2 auf, die zwei Druckköpfe 3, 4 umfasst. Jedem der Druckköpfe 3, 4 ist ein Drucktisch 5 beziehungsweise 6 zugeordnet. Der Drucktisch 5 weist eine erste Transporteinrichtung 7 sowie eine zweite Transporteinrichtung 8 auf, die jeweils zum Transportieren eines Substrats in einer Ebene dienen. Die Transporteinrichtung 7 ist dabei derart ausgebildet, dass sie ein Substrat in einer ersten Ebene 9 parallel zu der Druckeinrichtung 2 transportieren und bezüglich des Druckkopfs 3 ausrichten kann. Die Transporteinrichtung 8 ist fest mit der Transporteinrichtung 7 verbunden - aus Gründen der Übersichtlichkeit sind hier entsprechende Verbindungen zwischen den Transporteinrichtungen 7 und 8 nicht dargestellt - und dient zum Transportieren eines Substrats in einer zweiten Ebene 10, die sich parallel zu der ersten Ebene 9 erstreckt. Da die Transporteinrichtungen 7 und 8 fest miteinander verbunden sind, weisen die Ebenen 9 und 10 einen festen Abstand A zueinander auf. Der Drucktisch 5 weist weiterhin eine Hubeinrichtung 11 auf, die zum Verfahren der ersten Transporteinrichtung 7 und damit auch zum Verfahren der zweiten Transporteinrichtung 8 dient. Die Hubeinrichtung 11 ist derart ausgebildet, dass sie die erste Transporteinrichtung mit der ersten Ebene 9 zwischen einer Transportebene 12 und einer der Druckeinrichtung 2 zugeordneten Druckebene 13 verfährt. Die Lagen der Transportebene 12 sowie der Druckebene 13 sind hierbei durch gestrichelte Linien angedeutet, wobei die Transportebene 12 und die Druckebene 13 ebenfalls den Abstand A zueinander aufweisen.

Der weitere Drucktisch 6 weist eine weitere erste Transporteinrichtung 14 sowie eine weitere zweite Transporteinrichtung 15 auf, die den Transporteinrichtungen 7 und 8 entsprechen, wobei die weitere erste Transporteinrichtung 14 zum Transportieren und Ausrichten eines Substrats in einer weiteren ersten Ebene 16 und die weitere zweite Transporteinrichtung 15 zum Transportieren eines Substrats in einer weiteren zweiten Ebene 17 dient. Die Ebenen 16 und 17 sind aufgrund der festen Verbindung zwischen den Transporteinrichtungen 14 und 15 in dem festen Abstand A zueinander angeordnet, der dem Abstand A zwischen den Ebenen 9 und 10 entspricht. Weiterhin umfasst der weitere Drucktisch 6 eine Hubeinrichtung 18, die analog zu der Hubeinrichtung 11 die Transporteinrichtung 14 mit ihrer Ebene 16 zwischen der Transportebene 12 und der Druckebene 13 verfährt. Die Hubeinrichtungen 11 und 18 sind bevorzugt als motorische, insbesondere elektromotorische, pneumatische oder hydraulische Hubzylinder, oder auf andere, dem Fachmann bekannte Art und Weise ausgebildet.

Weiterhin umfasst die Drucktischanordnung 1 eine Zuführeinrichtung 19 sowie eine Abführeinrichtung 20, die zum Transportieren der Substrate in der Transportebene 12 dienen. Die Zuführeinrichtung 19 ist dem Drucktisch 5 zugeordnet und derart ausgebildet, dass sie ein Substrat in der Transportebene 12 transportiert und bei Bedarf der Transporteinrichtung 7 zuführt. Die Abführeinrichtung 20 ist dem Drucktisch 6 zugeordnet und derart ausgebildet, dass sie von der in der Transportebene 12 liegenden Transporteinrichtung 14 oder 15 ein insbesondere bedrucktes Substrat aufnehmen und von der Drucktischanordnung 1 abführen beziehungsweise wegführen kann.

Die Transporteinrichtungen 7, 8, 14, 15 sowie die Zuführeinrichtung 19 und die Abführeinrichtung 20 sind vorzugsweise jeweils förderbandartig ausgebildet, um die Substrate durch die Drucktischanordnung 1 zumindest in Richtung des Pfeils 21 von der Zuführeinrichtung 19 bis zu der Abführeinrichtung 20 zu transportieren. Die Transporteinrichtungen 7, 8 und 14 und 15 sind derart ausgebildet, dass die jeweils in der Transportebene 12 liegenden Transporteinrichtungen der benachbarten Drucktische 5 und 6 Substrate von einer Transporteinrichtung zu der benachbarten Transporteinrichtung führen können. Die Funktionsweise der Drucktischanordnung 1 soll im Folgenden anhand eines Ausführungsbeispiels erläutert werden.

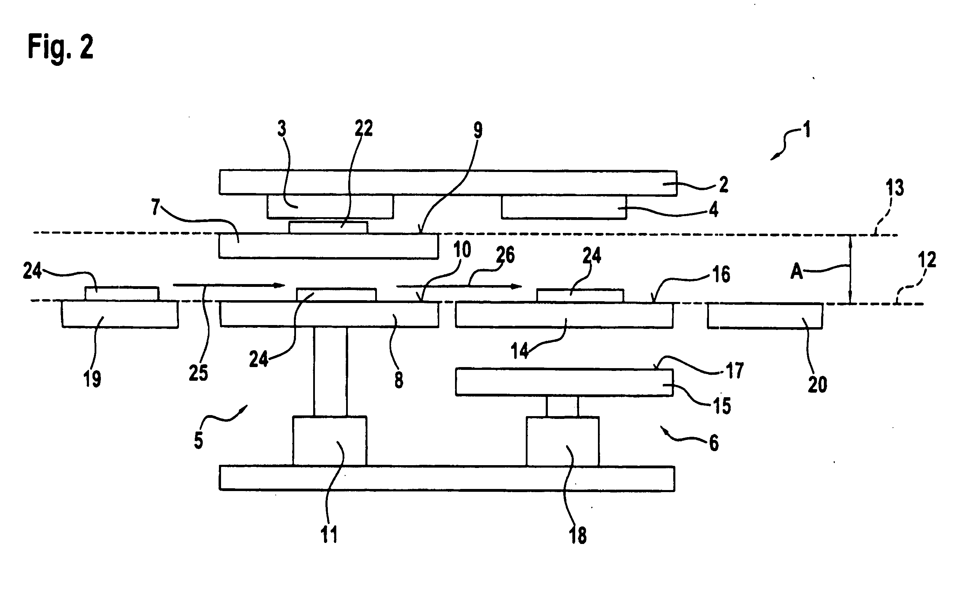

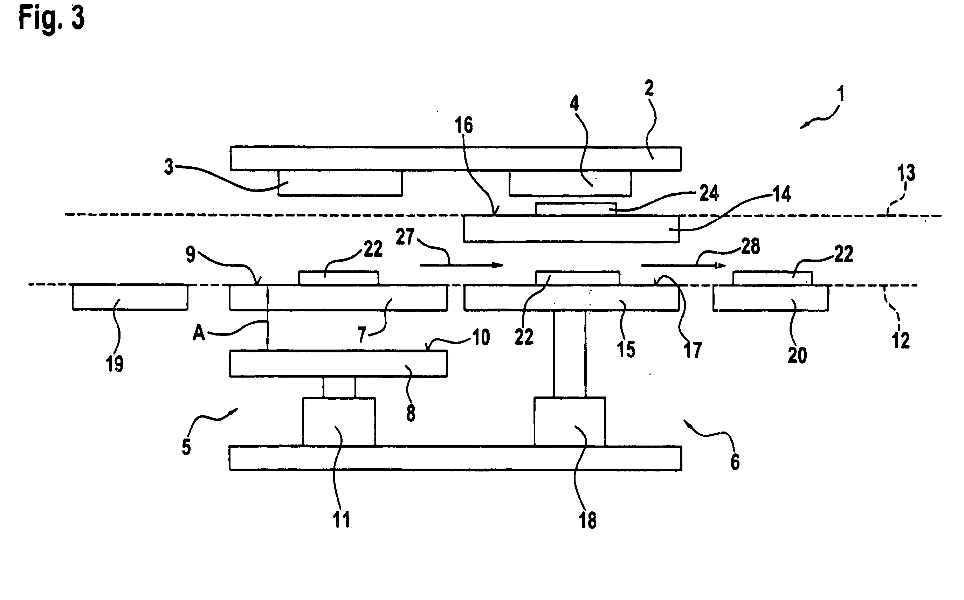

Figur 1 zeigt einen möglichen Ausgangszustand der Drucktischanordnung 1 bei der Inbetriebnahme. Figuren 2 und 3 zeigen die Drucktischanordnung 1 in unterschiedlichen Druckstellungen, wobei aus Figur 1 bekannte Elemente mit den gleichen Bezugszeichen versehen sind, sodass insofern jeweils auf die obenstehende Beschreibung verwiesen wird.

Zunächst wird mittels der Zuführeinrichtung 19 ein erstes Substrat 22 der Transporteinrichtung 7 des Drucktischs 5 zugeführt, wie durch einen Pfeil 23 angedeutet. Anschließend wird die erste Transporteinrichtung 7 mittels der Hubeinrichtung 11 mit ihrer Ebene 9 in die Druckebene 13 verfahren beziehungsweise verlagert, wie in Figur 2 dargestellt. In dieser Betriebsstellung wird bevorzugt das Substrat 22 mittels der Transporteinrichtung 7 bezüglich des Druckkopfs 3 ausgerichtet und anschließend entsprechend bedruckt. Währenddessen wird mittels der Zuführeinrichtung 19 ein zweites Substrat der nunmehr mit ihrer Ebene 10 in der Transportebene 12 liegenden zweiten Transporteinrichtung 8 zugeführt, wie durch einen Pfeil 25 angedeutet. Die Transporteinrichtung 8 fördert das zweite Substrat 24 in der Transportebene 12 weiter zu der ersten Transporteinrichtung 14 des zweiten Drucktischs 6, deren Ebene 16 sich ebenfalls in der Transportebene 12 befindet, wie durch einen Pfeil 26 angedeutet. Während also das erste Substrat 22 bedruckt und weiter ausgerichtet wird, wird das zweite Substrat 24 bereits zu dem zweiten Drucktisch 6 und dessen erster Transporteinrichtung 14 gefördert.

Anschließend wird die erste Transporteinrichtung 14 mit ihrer Ebene 16 aus der Transportebene 12 in die Druckebene 13 mittels der Hubeinrichtung 18 verfahren, wie in Figur 3 dargestellt. Hier befindet sich die weitere erste Transporteinrichtung 14 des weiteren Drucktischs 6 mit ihrer Ebene 16 in der Druckebene 13, sodass das Substrat 24 durch den Druckkopf 4 bedruckbar ist. Gegebenenfalls wird das Substrat 24 vor dem Druckvorgang durch die Transporteinrichtung 14 bezüglich des Druckkopfs 4 ausgerichtet beziehungsweise justiert. Ist der Druckvorgang an dem Drucktisch 5 beendet, wird, wie weiterhin in Figur 3 dargestellt, die Transporteinrichtung 7 mittels der Hubeinrichtung 11 wieder zurück in ihre Ausgangsposition verlagert, sodass die Ebene 9 in der Transportebene 12 liegt. Das nunmehr bedruckte Substrat 22 wird nun der nunmehr in der Transportebene 12 liegenden zweiten Transporteinrichtung 15 des zweiten Drucktischs 6, wie durch einen Pfeil 27 angedeutet, zugeführt. Die Transporteinrichtung 15 transportiert das Substrat 22 weiter und führt es der Abführeinrichtung 20, wie durch einen Pfeil 28 angedeutet, zu, sodass das bedruckte erste Substrat 22 die Drucktischanordnung 1 verlässt und beispielsweise in eine Stapel-, Verpackungs- oder Weiterverarbeitungsvorrichtung geführt wird. Sobald das Substrat 22 den ersten Drucktisch 5 verlassen hat, kann mittels der Zuführeinrichtung 19 ein neues Substrat der Transporteinrichtung 7 beziehungsweise dem ersten Drucktisch 5 zum Bedrucken zugeführt werden. Sobald das Substrat 24 durch den Druckkopf 4 bedruckt wurde, wird mittels der Hubeinrichtung 18 die Transporteinrichtung 14 zurück in ihre Ausgangslage verfahren, sodass die Ebene 16 in der Transportebene 12 liegt, und das nunmehr bedruckte Substrat 24 ebenfalls der Abführeinrichtung 20 zur Weiterbearbeitung oder zum Abtransport zugeführt wird, wie in Figur 1 durch einen Pfeil 29 angedeutet. Während die Hubeinrichtung 18 des Drucktischs 6 die Transporteinrichtungen 16 und 15 in ihre Ausgangslage zurück verfährt, verfährt die Hubeinrichtung 11 des Drucktischs 5 bevorzugt die Transporteinrichtungen 7 und 8 in ihre Druckposition, sodass die Transporteinrichtung 7 mit ihrer Ebene 9 in der Druckebene 13 liegt. Die Drucktische 5 und 6 werden somit vorzugsweise abwechselnd verlagert beziehungsweise verfahren, um die jeweiligen Substrate in Druckposition zu bringen. Da der Abstand zwischen den Ebenen 9 und 10 beziehungsweise 16 und 17 dem Abstand zwischen der Transportebene 12 und der Druckebene 13 entspricht, ist stets gewährleitstet, dass durch den jeweiligen Drucktisch 5 oder 6, der sich in seiner Druckstellung befindet, ein weiteres Substrat hindurch förderbar ist. Somit wird der Zeitaufwand zum Bedrucken mehrerer Substrate mittels der Drucktischanordnung erheblich verringert.

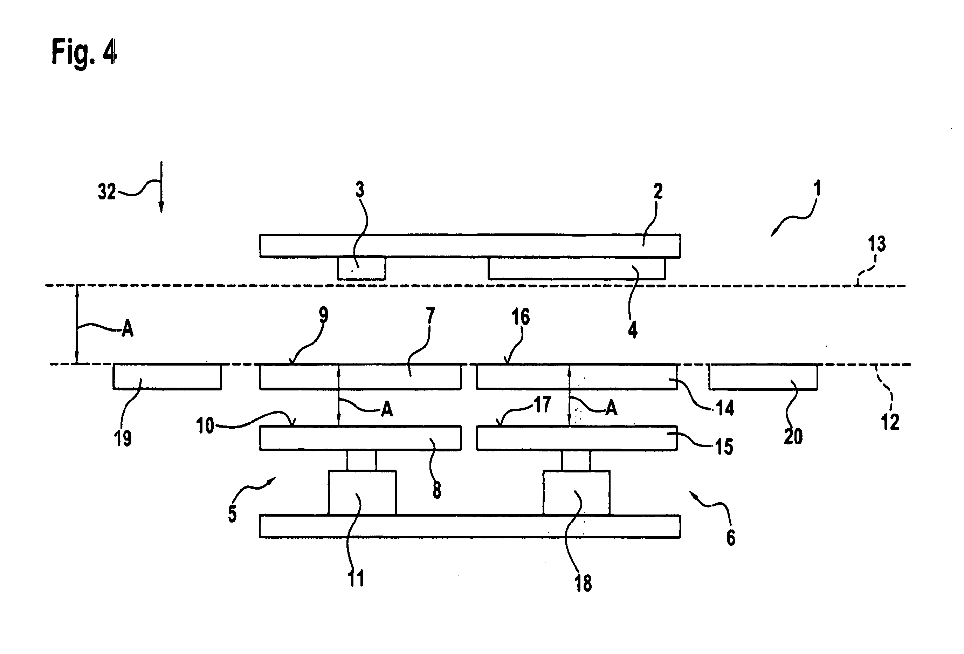

Figur 4 zeigt eine Weiterbildung der Drucktischanordnung 1, wobei aus den vorhergehenden Figuren bekannte Elemente mit den gleichen Bezugszeichen versehen sind, sodass insofern auf die obenstehende Beschreibung verwiesen wird. Im Folgenden soll im Wesentlichen nur auf die Unterschiede eingegangen werden. Die Ausführungsform gemäß Figur 4 unterscheidet sich von der vorhergehenden Ausführungsform der Drucktischanordnung 1 dahingehend, dass die Drucktische 5 und 6 zum Bedrucken unterschiedlicher Substrate ausgebildet sind. Dies ist in Figur 4 durch unterschiedlich große Druckköpfe 3 und 4 angedeutet. Die Druckköpfe 3 und 4 sind insbesondere zum Bedrucken unterschiedlich langer Substrate - in Transportrichtung gemäß Pfeil 21 gesehen - ausgebildet, die bevorzugt die gleiche Breite aufweisen. Werden bevorzugt abwechselnd unterschiedlich lange Substrate mittels der Zuführeinrichtung 19 den Drucktischen 5 und 6 zugeführt, so können kontinuierlich unterschiedliche Substrate an den zwei Drucktischen 5 und 6 bedruckt werden.

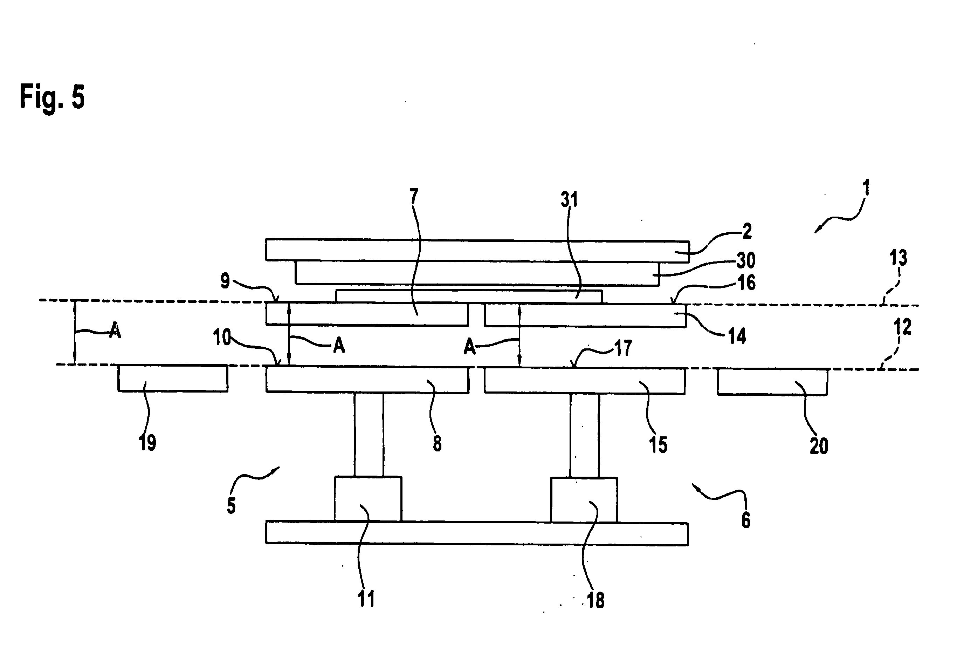

Figur 5 zeigt eine weitere Ausführungsform der Drucktischanordnung 1, die sich von den vorhergehenden Drucktischanordnungen im Wesentlichen darin unterscheidet, dass ein einziger Druckkopf 30 vorgesehen ist, der sich im Wesentlichen über die gesamte Breite der Drucktischanordnung 1 erstreckt. Werden die Hubeinrichtungen 11 und 18 derart angesteuert, dass die ersten Transporteinrichtungen 7 und 14 parallel zueinander verlagert beziehungsweise verfahren werden, so ist es möglich, ein überlanges Substrat 31, also ein Substrat, das länger als einer der Drucktische ausgebildet ist, mittels beider Drucktische 5 und 6 in die Druckebene 13 beziehungsweise in Druckposition zu verfahren und mittels des Druckkopfs 30 zu bedrucken. Besonders bevorzugt sind die Druckköpfe 3 und 4 derart ausgebildet, dass sie sich seitlich derart verfahren lassen, um den in Figur 5 dargestellten Druckkopf 30 zu bilden.

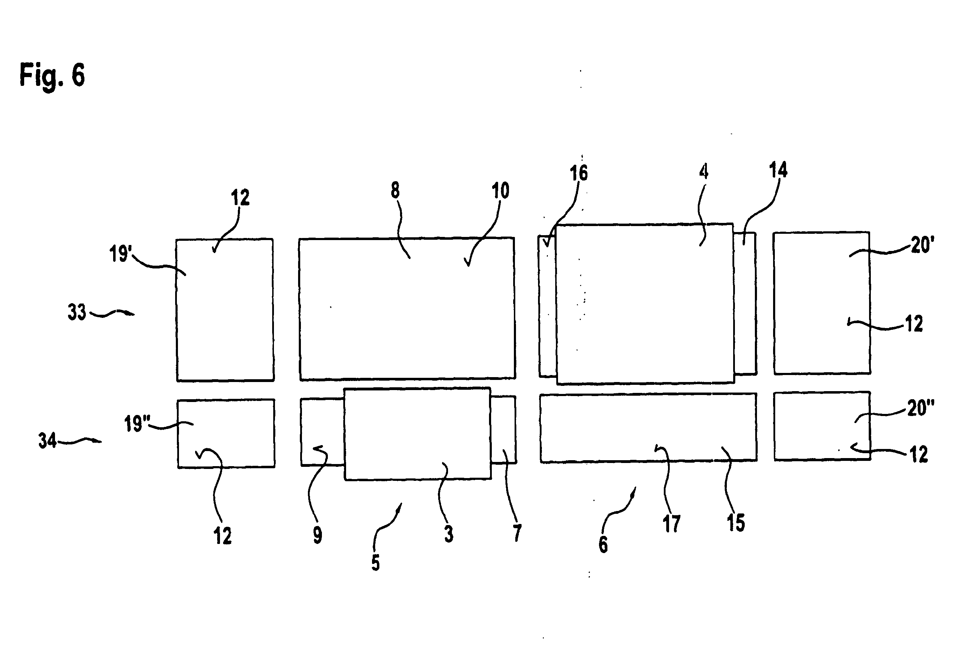

Figur 6 zeigt eine weitere Ausführungsform der Drucktischanordnung 1 in einer vereinfachten Darstellung, jedoch diesmal in einer Draufsicht in Richtung des Pfeils 32, wie er in Figur 4 dargestellt ist. Während bezüglich der vorhergehenden Ausführungsformen davon ausgegangen wurde, dass die Transporteinrichtungen 7, 8 und 14, 15 jeweils direkt übereinander beziehungsweise untereinander angeordnet sind, sodass in einer Draufsicht aus Richtung des Pfeils 32 sich die jeweiligen Transporteinrichtungen überdecken, ist gemäß der Ausführungsform in Figur 6 vorgesehen, dass die Transporteinrichtungen 7, 8 und 14, 15 jeweils seitlich versetzt zueinander beziehungsweise nebeneinander an dem jeweiligen Drucktisch 5 beziehungsweise 6 angeordnet sind. Während die Zuführeinrichtung 19, die vorliegend aus zwei Zuführvorrichtungen 19' und 19" gebildet wird, und die Abführeinrichtung 20, die vorliegend von zwei nebeneinander angeordneten Abführvorrichtungen 20' und 20" gebildet wird, weiterhin in der Transportebene 12 liegen, liegen auch die Transporteinrichtungen 7, 8 und 15, 14, wie zuvor beschrieben, in unterschiedlichen Ebenen, je nach Verfahrweg der jeweiligen Hubeinrichtung 11, 18. Zwar werden gemäß dieser Ausführungsform mehrere Zuführeinrichtungen und Abführeinrichtungen benötigt, jedoch können hierdurch nicht nur unterschiedlich lange, sondern auch unterschiedlich breite Substrate mittels der Drucktischanordnung 1 wie oben beschrieben bedruckt werden. Die Zuführvorrichtung 19', die Transporteinrichtungen 8 und 14 sowie die Abführeinrichtung 20' bilden hierbei eine erste Transportlinie 33 für Substrate mit einer maximalen ersten Breite, und die Zuführvorrichtung 19", die Transporteinrichtungen 7 und 15 sowie die Abführvorrichtung 20" eine zweite Transportlinie 34 für Substrate mit einer maximalen zweiten Breite, die kleiner ist als die maximale erste Breite. Die Transportlinien 33 und 34 finden sich ebenfalls in den oben beschriebenen Ausführungsformen wieder, bei denen die Transporteinrichtungen nicht nebeneinander, sondern übereinander angeordnet sind, sodass lediglich eine Zuführeinrichtung 19 beziehungsweise nur eine Abführeinrichtung 20 notwendig ist.

Die beschriebene vorteilhafte Drucktischanordnung 1 kann in ihren oben beschriebenen Variationen bevorzugt auch noch durch weitere, entsprechend ausgebildete Drucktische, die sich in Transportrichtung anschließen, ergänzt werden.

## Patentansprüche

1. Drucktischanordnung (1) mit wenigstens einer Druckeinrichtung (2) zum Bedrucken von Substraten (22,24,31) und mit mindestens einem Drucktisch (5), der eine erste Transporteinrichtung (7) zum Transportieren der zu bedruckenden Substrate (22,24,31) in einer ersten Ebene (9) und eine Hubeinrichtung (11) zum Verfahren der ersten Transporteinrichtung (7) mit der ersten Ebene (9) zwischen einer der Druckeinrichtung (2) zugeordneten Druckebene (13) und einer darunter liegenden Transportebene (12) aufweist, **dadurch gekennzeichnet,** dass der Drucktisch (5) eine zweite Transporteinrichtung (8) zum Transportieren von Substraten (22,24,31) in einer zweiten Ebene (10) unterhalb der ersten Ebene (9) aufweist, wobei der feste Abstand (A) zwischen der ersten Ebene (9) und der zweiten Ebene (10) dem Abstand (A) zwischen der Druckebene (13) und der Transportebene (12) entspricht.

2. Drucktischanordnung nach Anspruch 1, **dadurch gekennzeichnet,** dass dem Drucktisch (5) eine Zuführeinrichtung (19) zum Zuführen der Substrate (22,24,31) in der Transportebene (12) zugeordnet ist.

3. Drucktischanordnung nach einem der vorhergehenden Ansprüche, **gekennzeichnet durch** mindestens einen weiteren Drucktisch (6), der in Transportrichtung der Transporteinrichtungen (7,8) hinter dem Drucktisch (5) angeordnet ist und mindestens eine weitere erste Transporteinrichtung (14) zum Transportieren zu bedruckender Substrate (22,24,31) in einer ersten Ebene (16) und eine weitere Hubeinrichtung (18) zum Verfahren der weiteren ersten Transporteinrichtung (14) mit der ersten Ebene (16) zwischen der Druckebene (1) und der darunterliegenden Transportebene (13) aufweist.

4. Drucktischanordnung nach einem der vorhergehenden Ansprüche, **dadurch gekennzeichnet,** dass der weitere Drucktisch (6) eine weitere zweite Transporteinrichtung (15) zum Transportieren von Substraten (22,24,31) in einer zweiten Ebene (17) unterhalb der ersten Ebene (16) aufweist, wobei der feste Abstand (A) zwischen der ersten Ebene (16) und der zweiten Ebene (17) der weiteren Transporteinrichtungen (14,15) dem Abstand (A) zwischen der Druckebene (13) und der Transportebene (12) entspricht.

5. Drucktischanordnung nach Anspruch 4, **dadurch gekennzeichnet,** dass die in der Transportebene (12) oder in der Druckebene liegenden, benachbarten Transporteinrichtungen (7,8,14,15) der Drucktische (5,6) jeweils zur Weiterleitung der Substrate (22,24,31) von einer Transporteinrichtung (7,8,14,15) eines der Drucktische (5,6) zu der benachbarten Transporteinrichtung (7,8,14,15) eines anderen der Drucktische (5,6) ausgebildet sind.

6. Drucktischanordnung nach einem der vorhergehenden Ansprüche, **dadurch gekennzeichnet,** dass die erste und die zweite Transporteinrichtung (7,8,14,15) des jeweiligen Drucktischs (5,6) übereinander oder seitlich versetzt zueinander angeordnet sind.

7. Drucktischanordnung nach einem der vorhergehenden Ansprüche, **dadurch gekennzeichnet,** dass die Druckeinrichtung (2) einen Druckkopf (30) für mehrere Drucktische (5,6) und/oder wenigstens einen Druckkopf (3,4) für jeweils einen der Drucktische (5,6) aufweist.

8. Verfahren zum Betreiben einer Drucktischanordnung (1) nach einem oder mehreren der vorhergehenden Ansprüche, mit wenigstens einer Druckeinrichtung (2) zum Bedrucken von Substraten (22,24,31) und mit mindestens einem Drucktisch (5), der eine erste Transporteinrichtung (7) zum Transportieren der zu bedruckenden Substrate (22,24,31) in einer ersten Ebene (9) und eine Hubeinrichtung (11) zum Verfahren der ersten Transporteinrichtung (7) mit der ersten Ebene (9) zwischen einer der Druckeinrichtung (2) zugeordneten Druckebene (13) und einer darunterliegenden Transportebene (12) aufweist, der Drucktisch (5) eine zweite Transporteinrichtung (8) zum Transportieren von Substraten (22,24,31) in einer zweiten Ebene (10) unterhalb der ersten Ebene (9) aufweist, und wobei der feste Abstand (A) zwischen der ersten Ebene (9) und der zweiten Ebene (10) dem Abstand (A) zwischen der Druckebene (13) und der Transportebene (12) entspricht, mit folgenden Schritten:
- Verfahren der ersten Transporteinrichtung (7) mit der ersten Ebene (9) in die Transportebene (12),
- Zuführen eines ersten Substrats (22) der ersten Transporteinrichtung (7) des Drucktischs (5),
- Verfahren der ersten Transporteinrichtung (7) mit der ersten Ebene (9) in die Druckebene (13) zum Bedrucken des ersten Substrats (22) mittels der Druckeinrichtung (2),
- Zuführen eines zweiten Substrats (24) zu der in der Transportebene (12) liegenden zweiten Transporteinrichtung (8) und Transportieren des zweiten Substrats (24) mittels der zweiten Transporteinrichtung (8) durch den Drucktisch (5), während die Druckeinrichtung (2) das erste Substrat (22) bedruckt.

9. Verfahren nach Anspruch 8, **dadurch gekennzeichnet,** dass das zweite Substrat (24) einer weiteren ersten Transporteinrichtung (14) eines weiteren Drucktischs (6) durch die zweite Transporteinrichtung (8) des Drucktischs (5) zugeführt wird.

10. Verfahren nach Anspruch 9, **dadurch gekennzeichnet,** dass die erste Transporteinrichtung (14) des weiteren Drucktischs (6) mittels einer Hubeinrichtung (18) in die Druckebene (19) zum Bedrucken des zweiten Substrats (24) durch die Druckeinrichtung (2) verlagert wird.

11. Verfahren nach Anspruch 10, **dadurch gekennzeichnet,** dass die erste Transporteinrichtung (7) des Drucktischs (5) mit dem bedruckten ersten Substrat (22) in die Transportebene (12) verfahren und das bedruckte Substrat (22) durch die erste Transporteinrichtung (7) des Drucktischs (5) einer weiteren zweiten Transporteinrichtung (15) des weiteren Drucktischs (6) zugeführt wird, während die Druckeinrichtung (2) das zweite Substrat (24) bedruckt.

## Claims

1. Printing table arrangement (1) with at least one printing device (2) for printing on substrates (22, 24, 31) and with at least one printing table (5), which has a first transport device (7) to transport the substrates (22, 24, 31) to be printed on in a first plane (9) and a lifting device (11) to move the first transport device (7) with the first plane (9) between a printing plane (13) assigned to the printing device (2) and a transport plane (12) lying underneath, **characterized in** that that the printing table (5) has a second transport device (8) to transport substrates (22, 24, 31) in a second plane (10) beneath the first plane (9), in which the fixed spacing (A) between the first plane (9) and the second plane (10) corresponds to the spacing (A) between the printing plane (13) and transport plane (12).

2. Printing table arrangement according to claim 1, **characterized in** that a feed device (19) is assigned to the printing table (5) to feed the substrates (22, 24, 31) in the transport plane (12).

3. Printing table arrangement according to one of the preceding claims, **characterized by** at least one additional printing table (6), which is arranged in the transport direction of the transport devices (7, 8) behind printing table (5) and has at least one additional first transport device (14) to transport the substrates (22, 24, 31) to be printed on in a first plane (16) and an additional lifting device (18) to move the additional first transport device (14) with the first plane (16) between the printing plane (1) and the transport plane (13) lying underneath.

4. Printing table arrangement according to one of the preceding claims, **characterized in** that the additional printing table (6) has an additional second transport device (15) to transport substrates (22, 24, 31) in a second plane (17) beneath the first plane (16), in which the fixed spacing (A) between the first plane (16) and the second plane (17) of the additional transport devices (14, 15) corresponds to the spacing (A) between the printing plane (13) and the transport plane (12).

5. Printing table arrangement according to claim 4, **characterized in** that the adjacent transport devices (7, 8, 14, 15) of the printing tables (5, 6) lying in the transport plane (12) or in the printing plane are each designed to convey the substrates (22, 24, 31) from one transport device (7, 8, 14, 15) of one of the printing tables (5, 6) to the adjacent transport device (7, 8, 14, 15) of another printing table (5, 6).

6. Printing table arrangement according to one of the preceding claims, **characterized in** that the first and second transport devices (7, 8, 14, 15) of the corresponding printing table (5, 6) are arranged one above the other or laterally offset to each other.

7. Printing table arrangement according to one of the preceding claims, **characterized in** that the printing device (2) has a printing head (30) for several printing tables (5, 6) and/or at least one printing head (3, 4) for each of the printing tables (5, 6).

8. Method for operation of a printing table arrangement (1), according to one or more the preceding claims, with at least one printing device (2) for printing on substrates (22, 24, 31) and with at least one printing table (5), which has first transport device (7) to transport the substrates (22, 24, 31) to be printed on in a first plane (9) and a lifting device (11) to move the first transport device (7) with the first plane (9) between a printing plane (13) assigned to the printing device (2) and a transport plane (12) lying underneath, in which the printing table (5) has a second transport device (8) to transport substrates (22, 24, 31) in a second plane (10) beneath the first plane (9), and in which the fixed spacing (A) between the first plane (9) and the second plane (10) corresponding to the spacing (A) between the printing plane (13) and the transport plane (12) with the following steps:
- moving of the first transport device (7) with the first plane (9) in the transport plane (12),
- feeding of a first substrate (22) to the first transport device (7) of printing table (5),
- moving of the first transport device (7) with the first plane (9) in the printing plane (13) for printing on a first substrate (22) by means of the printing device (2),
- feeding of a second substrate (24) to the second transport device (8) lying in the transport plane (12) and transport of the second substrate (24) by means of the second transport device (8) through the printing table (5) while the printing device (2) is printing on the first substrate (22).

9. Method according to claim 8, **characterized in** that the second substrate (24) is fed to an additional first transport device (14) of an additional printing table (6) by the second transport device (8) of the printing table (5).

10. Method according to claim 9, **characterized in** that the first transport device (14) of the additional printing table (6) is moved by means of a lifting device (18) into the printing plane (19) for printing on the second substrate (24) by the printing device (2).

11. Method according to claim 10, **characterized in** that the first transport device (7) of the printing table (5) with the printed first substrate (22) is moved in the transport plane (12) and the printed substrate (22) is fed by the first transport device (7) of printing table (5) to an additional second transport device (15) of an additional printing table (6), while the printing device (2) is printing on the second substrate (24).

## Revendications

1. Agencement de table d'impression (1) comprenant au moins un dispositif d'impression (2) pour imprimer des substrats (22, 24, 31) et au moins une table d'impression (5) qui présente un premier dispositif de transport (7) pour transporter les substrats (22, 24, 31) à imprimer dans un premier plan (9), et un dispositif de levage (11) pour déplacer le premier dispositif de transport (7) avec le premier plan (9) entre un plan d'impression (13) correspondant au dispositif d'impression (2) et un plan de transport (12) situé en-dessous, **caractérisé en ce** que la table d'impression (5) présente un second dispositif de transport (8) pour transporter des substrats (22, 24, 31) dans un second plan (10) en-dessous du premier plan (9), sachant que la distance fixe (A) entre le premier plan (9) et le second plan (10) correspond à la distance (A) entre le plan d'impression (13) et le plan de transport (12).

2. Agencement de table d'impression selon la revendication 1, **caractérisé en ce** qu'un dispositif d'amenée (19) pour alimenter les substrats (22, 24, 31) est attribué à la table d'impression (5) dans le plan de transport (12).

3. Agencement de table d'impression selon l'une des revendications précédentes, **caractérisé par** au moins une table d'impression (6) supplémentaire qui est disposée derrière la table d'impression (5) dans le sens de transport des dispositifs de transport (7, 8), et au moins un premier dispositif de transport (14) supplémentaire pour transporter des substrats (22, 24, 31) à imprimer dans un premier plan (16), et un dispositif de levage (18) supplémentaire pour déplacer le premier dispositif de transport (14) supplémentaire avec le premier plan (16) entre le plan d'impression (1) et le plan de transport (13) placé dessous.

4. Agencement de table d'impression selon l'une des revendications précédentes, **caractérisé en ce** que la table d'impression (6) supplémentaire présente un second dispositif de transport (15) supplémentaire pour transporter des substrats (22, 24, 31) dans un second plan (17) en-dessous du premier plan (16), sachant que la distance fixe (A) entre le premier plan (16) et le second plan (17) des dispositifs de transport (14, 15) supplémentaires correspond à la distance (A) entre le plan d'impression (13) et le plan de transport (12).

5. Agencement de table d'impression selon la revendication 4, **caractérisé en ce** que les dispositifs de transport (7, 8, 14, 15) voisins des tables d'impression (5, 6), situés dans le plan de transport (12) ou dans le plan d'impression, sont conçus respectivement pour transférer les substrats (22, 24, 31)d'un dispositif de transport (7, 8, 14, 15) d'une des tables d'impression (5, 6) au dispositif de transport (7, 8, 14, 15) voisin d'une autre des tables d'impression (5, 6).

6. Agencement de table d'impression selon l'une des revendications précédentes, **caractérisé en ce** que le premier et le second dispositif de transport (7, 8, 14, 15) de la table d'impression (5, 6) respective sont disposés en étant l'un sur l'autre ou décalés latéralement.

7. Agencement de table d'impression selon l'une des revendications précédentes, **caractérisé en ce** que le dispositif d'impression (2) présente une tête d'impression (30) pour plusieurs tables d'impression (5, 6) et/ou au moins une tête d'impression (3, 4) pour respectivement une des tables d'impression (5, 6).

8. Procédé destiné au fonctionnement d'un agencement de tables d'impression (1) selon l'une ou plusieurs des revendications précédentes, comprenant au moins un dispositif d'impression (2) pour imprimer des substrats (22, 24, 31) et au moins une table d'impression (5) qui présente un premier dispositif de transport (7) pour transporter les substrats (22, 24, 31) à imprimer dans un premier plan (9), et un dispositif de levage (11) pour déplacer le premier dispositif de transport (7) avec le premier plan (9) entre un plan d'impression (13) correspondant au dispositif d'impression (2) et un plan de transport (12) situé en-dessous, la table d'impression (5) présente un second dispositif de transport (8) pour transporter des substrats (22, 24, 31) dans un second plan (10) en-dessous du premier plan (9), et sachant que la distance fixe (A) entre le premier plan (9) et le second plan (10) correspond à la distance (A) entre le plan d'impression (13) et le plan de transport (12), avec les étapes suivantes :
- déplacement du premier dispositif de transport (7) avec le premier plan (9) dans le plan de transport (12),
- amenée d'un premier substrat (22) au premier dispositif de transport (7) de la table d'impression (5),
- déplacement du premier dispositif de transport (7) avec le premier plan (9) dans le plan d'impression (13) pour imprimer le premier substrat (22) au moyen du dispositif d'impression (2),
- amenée d'un deuxième substrat (24) au deuxième dispositif de transport (8) situé dans le plan de transport (12) et transport du deuxième substrat (24) au moyen du deuxième dispositif de transport (8) à travers la table d'impression (5) pendant que le dispositif d'impression (2) imprime le premier substrat (22).

9. Procédé selon la revendication 8, **caractérisé en ce** que le deuxième substrat (24) d'un premier dispositif de transport (14) supplémentaire d'une table d'impression (6) supplémentaire est amené au moyen du deuxième dispositif de transport (8) de la table d'impression (5).

10. Procédé selon la revendication 9, **caractérisé en ce** que le premier dispositif de transport (14) de la table d'impression (6) supplémentaire est déplacé dans le plan d'impression (19) au moyen d'un dispositif de levage (18) pour imprimer le deuxième substrat (24) au moyen du dispositif d'impression (2).

11. Procédé selon la revendication 10, **caractérisé en ce** que le premier dispositif de transport (7) de la table d'impression (5) est déplacé avec le premier substrat (22) imprimé dans le plan de transport (12) et le substrat (22) imprimé est amené au moyen du premier dispositif de transport (7) de la table d'impression (5) d'un deuxième dispositif de transport (15) supplémentaire de la table d'impression (6) supplémentaire, pendant que le dispositif d'impression (2) imprime le deuxième substrat (24).
